# EUROPEAN PATENT APPLICATION

(11) **EP 1 052 832 A1**
(43) Date of publication of application: **15.11.2000**
(21) Application number: 99830297.0
(22) Date of filing: 14.05.1999
(51) Int. Cl.: H04M 1/60, H03G 3/34

(54) **Receiving section of a telephone**

(71) Applicant: STMicroelectronics S.r.l., 20041 Agrate Brianza (Milano) (IT)
(72) Inventor: Nicollini, Germano, 29100 Piacenza (IT); Pernici, Sergio, 24121 Bergamo (IT)
(74) Representative: Maggioni, Claudio

(57) **Abstract**

A processing unit (11) with balanced outputs transfers a received digital signal (RX-IN) to an amplification unit (12) with balanced inputs and outputs. A control unit (20) enables or disables the processing (11) and amplification (12) units in response to a power up/power down signal (PD). To prevent disturbances due to power up/power down transients from appearing in the acoustic transducer (13) connected between the outputs of the amplification unit (12), switches (M1A, M1B) are provided between the outputs of the processing unit (11) and the inputs of the amplification unit (12), and delay means (21-24) are provided to produce, according to a predetermined program, enabling/disabling control signals for the processing (11) and amplification (12) units and control signals for the switches (M1A, M1B).

## Description

The present invention relates to a receiving section of a telephone, as defined in the precharacterizing clause of Claim 1.

The signal received by a telephone from a digital telephone network is first demodulated, then processed in digital form, converted to analogue form and finally amplified and applied to an electroacoustic transducer.

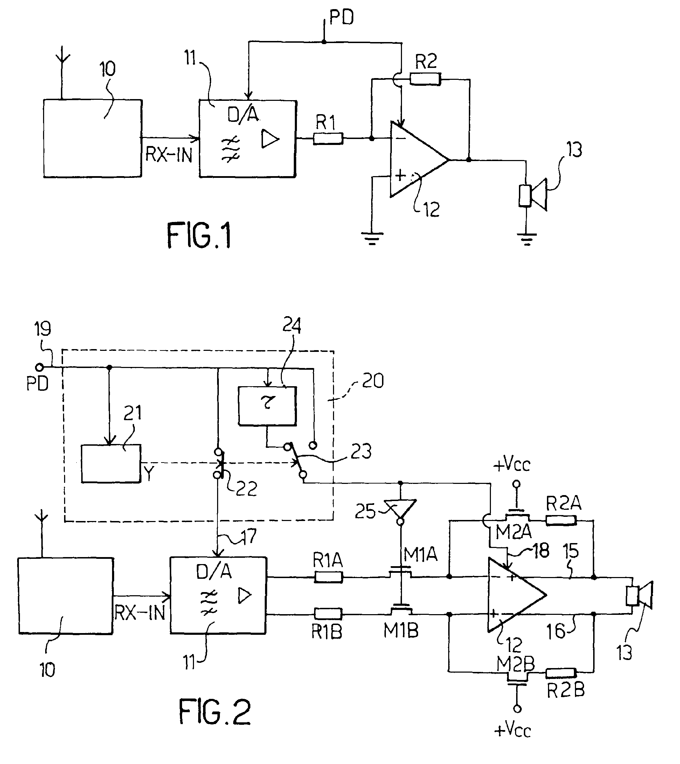

The receiving section of a telephone can be represented schematically as shown in Figure 1. A demodulated digital signal RX-IN produced by a receiving and demodulating unit 10 is applied to the input of a circuit unit 11, where it is converted to analogue form, filtered and amplified with respect to voltage. The analogue signal leaving the unit 11 is applied to the input of a power amplifier 12 which is capable of transferring the signal to an electroacoustic transducer 13, such as an electromagnetic earphone or a loudspeaker, with sufficient electrical power for its operation. The gain of the power amplifier 12 is determined by the ratio between the resistance of a feedback resistor R2 connected between the output and the inverting input of the amplifier and the resistance of a resistor R1 connected between the output of the unit 11 and the inverting input of the amplifier. To prevent the dissipation of power when the telephone is not in use, circuit means are provided both in the unit 11 and in the amplifier 12 to respond to an external enabling or disabling command. This function is represented by the connection of the unit 11 and of the amplifier 12 to a terminal to which a digital PD (Power Down) signal consisting of a single bit can be applied. Conventionally, the receiving circuit system is put into the state of zero current absorption by PD = 1 and is enabled to absorb power supply current by PD = 0 (Power Up).

As is known, whenever a change is made from the "Power Down" state to the "Power Up" state, or vice versa, both the signal processing unit and the power amplifier are subjected to an abrupt voltage and current transient before returning to the normal operation condition. During this transient, electrical perturbations are produced by components having frequencies in the acoustic band, which are manifested as annoying audible noises in the electroacoustic transducer.

Various arrangements, requiring the addition of active or passive components in series and/or in parallel with the transducer to filter the undesired electrical perturbations, have been adopted to overcome this problem. This type of solution, however, requires relatively bulky components outside the power amplifier which is normally formed as an integrated circuit.

The object of the present invention is to provide a receiving section for a telephone which is not subject to the problem described above and which can easily be integrated.

This object is achieved by making the receiving section defined and characterized in a general way in the first claim.

The invention will be more clearly understood from the following detailed description of some embodiments of it, provided by way of example and therefore without any restriction, with reference to the attached drawings, in which:
- Figure 1 is a block diagram of an ordinary receiving section of a telephone, and
- Figures 2 to 4 are block diagrams which illustrate three embodiments of the invention.

In Figure 2, in which elements identical or corresponding to those of Figure 1 are indicated by the same reference numbers, a processing unit 11 with a balanced structure receives at its input a demodulated digital signal RX-IN and supplies a balanced analogue signal at two outputs. The outputs of the unit 11 are coupled to the inputs of a differential amplifier 12: more particularly, each of them is connected to one of the inputs of the amplifier through a resistor R1A, R1B, in series with an n-channel MOS transistor M1A and M1B, acting as an electronic switch. Each of the differential outputs 15 and 16 of the amplifier 12 is connected, respectively, to the inverting and non-inverting input of the amplifier through a resistor R2A, R2B in series with a MOS transistor M2A, M2B biased for conduction. An electroacoustic transducer 13 is connected between the outputs 15 and 16 of the differential amplifier 12.

The processing unit 11 and the differential amplifier 12 are supplied from a voltage source (not shown), and each of them has circuit means which enable or disable the supply according to a signal applied to a corresponding enabling terminal 17 and 18.

A control unit 20 comprises a delay circuit 24 and a logic circuit 21 and has an input terminal 19 to which is applied a binary PD (Power Down) signal generated by a central circuit control unit (not shown) of the telephone. The logic circuit 21 responds to the PD signal by causing the closing or opening of an electronic switch 22 and an electronic changeover switch 23. The switch 22 connects the terminal 19 to the enabling terminal 17 of the processing unit 11, and the changeover switch 23 selectively connects the terminal 19 to the enabling terminal 18 of the differential amplifier 12 directly or through the delay circuit 24. The changeover switch 23 is used to additionally apply the PD signal, directly or through the delay circuit 24, to the gate electrodes of the n-channel MOS transistors M1A and M1B through an inverter 25. The inverter is necessary because the n-channel transistors M1A and M1B must be closed when the amplifier 12 is activated. Since this happens when the binary PD signal is at low level (PD=0), this signal must be inverted so that it has the necessary positive voltage to operate the n-channel transistors M1A and M1B. If p-channel transistors were used in place of the n-channel transistors, the inverter would not be necessary.

The operation of the circuit will now be considered. The delay circuit 24, the switch 22, the changeover switch 23 and the logic circuit 21 form, in combination, a delay unit which produces control signals according to a predetermined time program. In particular, the logic circuit 21 produces a signal Y = 1 if the PD signal is changing from 1 to 0, in other words from a power down state to a power up state, and produces a signal Y = 0 if the PD signal is changing from the 0 state to the 1 state, in other words from a power up state to a power down state. When Y = 1, the position of the switch 22 and that of the changeover switch 23 are as shown in the drawing; in other words, a 0 signal is applied to the terminal 17 at the instant of the closing of the switch 22 and the 0 signal is applied to the terminal 18 after a period of delay fixed by the delay circuit 24. The delay period is chosen to be sufficiently long to allow the processing unit 11 to settle. Thus the perturbations present at the output of the unit 11 have no effect on the amplifier 12 or on the electroacoustic transducer 13, because the amplifier remains off and the transistors M1A and M1B act as open circuits during the settling of the unit 11. At the end of the delay period fixed by the circuit 24, the amplifier 12 is also activated and the outputs of the unit 11 are connected to the inputs of the amplifier 12 through the MOS transistors M1A and M1B which are conducting. Since the input signal of the differential amplifier 12 is stable, any perturbation at the output of the amplifier can be due only to the settling of the amplifier. However, since the structure of the amplifier is balanced, the voltages present at the two outputs 15 and 16 due to settling perturbations will be in phase with each other and will therefore have no effect on the differential output signal Vout. There will therefore be no disturbances in the electroacoustic transducer 13.

In the presence of a power down signal (PD from 0 to 1), the signal emitted by the logic circuit 21 is at low level (Y = 0); this causes the opening of the switch 22 and the switching of the changeover switch 23, and therefore the amplifier 12 is disabled, the switches formed by the transistors M1A and M1B are opened and the unit 11 is disabled. The settling of the amplifier has no effect on the output, since the structure is differential, and that of the unit 11 has no effect on the output of the receiving section because the connections between the unit 11 and the amplifier 12 are interrupted by the opening of the transistors M1A and M1B. Clearly, the disabling of the amplifier 12 must take place simultaneously with the disabling of the unit 11, to avoid any disturbance in the transducer 13.

The function of the transistors M2A and M2B biased for conduction is only to introduce a supplementary resistance, equal to that of the transistors M1A and M1B when conducting, into the feedback circuit for the determination of the gain. The gain of the amplifier is determined from the ratio between the feedback resistance and the resistance in series with the input terminal. As is known, in the design of an integrated circuit it is not possible to specify the resistance of a single resistor precisely, owing to the wide variability of the manufacturing parameters, whereas it is possible to produce two resistors having a precise ratio between their resistances. The insertion of a transistor (M1A, M1B) in series with each of the inputs, and consequently of two resistances, modifies the ratio fixed at the design stage between the feedback resistance and the resistance in series with the inputs. The resistance of each of the conducting transistors M2A and M2B in series with the feedback resistors compensates this modification of the ratio.

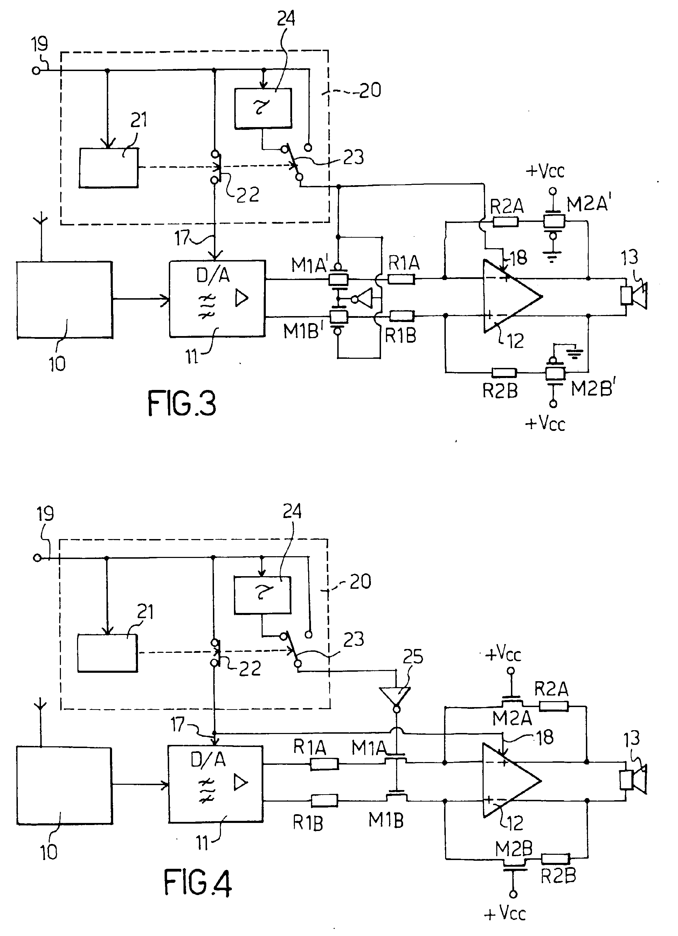

Figure 3 shows a variant in which the controlled connection between the unit 11 and the amplifier 12 is formed by electronic switches M1A' and M1B' connected before the resistors R1A and R1B, instead of after them as in Figure 2. In this case, it is preferable for the electronic switch to be formed by pairs of complementary transistors, since the dynamic range of the signal is greater than that of the circuit shown in Figure 2. To compensate the supplementary resistances of the pairs of complementary transistors, pairs of identical transistors M2A' and M2B' are provided in series with the feedback resistors R2A and R2B, preferably after them.

Figure 4 shows another variant in which the unit 11 and the amplifier 12 have their corresponding enabling/disabling terminals 17 and 18 both connected to the switch 22, so that they are enabled or disabled simultaneously, while the base electrodes of the transistors M1A and M1B are connected, through the inverter 25, to the changeover switch 23 as in Figure 2. With this configuration, the power-up time of the receiving section is shorter than that of the embodiment in Figure 2, since it is not the sum of the power-up time of the unit 11, or rather of the delay period of the circuit 24, and that of the amplifier 12, but is determined solely by the delay period of the circuit 24, or in other words, in practice, by the settling time of the unit 11.

As may be seen, the receiving section according to the invention makes it possible to avoid any disturbance in the electroacoustic transducer, since the propagation of the signal during the settling transients is substantially blocked. This is achieved without bulky external components, simply by using a few supplementary components which can easily be integrated.

## Claims

1. Receiving section of a telephone comprising
a unit (10) for receiving and demodulating the signal,
a unit (11) for processing the demodulated signal, having two balanced outputs and having first controllable enabling/disabling means (17),
an amplification unit (12) having two balanced inputs, each coupled to one of the outputs of the processing unit (11), having two balanced outputs (15, 16) coupled to an electroacoustic transducer (13) and having second controllable enabling/disabling means (18) and
a control unit (20) which is connected to the first and to the second enabling/disabling means (17, 18) of the processing and amplification units (11, 12) and which is capable of producing enabling/disabling control signals in response to a power up/power down signal (PD),
characterized in that it comprises controllable switch means (M1A, M1B) connected between the outputs of the processing unit (11) and the inputs of the amplification unit (12) and in that the control unit (20) comprises delay means (21-24) for producing the control signals of the first and second enabling/disabling means (17, 18), and for producing control signals for the switch means (M1A, M1B) according to a predetermined time program.

2. Receiving section according to Claim 1, in which the delay means (21-24) respond to a power up signal by producing an enabling control signal for the first and second enabling/disabling means (17, 18) of the processing unit (11) and of the amplification unit (12) and, with a predetermined delay (24) with respect to the power up command, a closing control signal for the switch means (M1A, M1B), and respond to a power down signal by producing a disabling signal for the first and second enabling/disabling means (17, 18) of the processing unit (11) and of the amplification unit (12).

3. Receiving section according to Claim 2, in which the delay means (21-24) respond to the power down signal with a signal for opening the switch means (M1A, M1B), this signal being approximately synchronous with the disabling signal.

4. Receiving section according to Claim 1, in which the delay means (21-24) respond to a power up signal by producing a first enabling control signal for the first enabling/disabling means (17) of the processing unit (11) and, with a predetermined delay (24) with respect to the power up control signal, a second enabling control signal for the second enabling/disabling means (18) of the amplification unit (12) and a closing control signal for the switch means (M1A, M1B), and respond to a power down signal by producing a disabling signal for the first and the second enabling/disabling means (17, 18) of the processing unit (11) and of the amplification unit (12).

5. Receiving section according to Claim 4, in which the delay means (21-24) respond to the power down signal with a signal for opening the switch means (M1A, M1B), this signal being approximately synchronous with the disabling signal.

6. Receiving section according to any one of the preceding claims, in which the amplification unit comprises a differential amplifier (12) with two inputs and two outputs and means of determining the gain, comprising first resistive means (R2A, R2B, M2A, M2B) connected between inputs and outputs and second resistive means (R1A, R1B) connected in series with the inputs, each of the first resistive means comprising a resistor (R2A, R2B) and a closed switch (M2A, M2B) having the same resistance as the corresponding switch means (M1A, M1B) when in the closed state.

7. Receiving section according to Claim 6, in which the switch means (M1A, M1B) are inserted between the inputs of the differential amplifier (12) and the corresponding second resistive means (R1A, R1B) and the closed switches (M2A, M2B) are inserted between the corresponding resistors (R2A, R2B) and the corresponding inputs of the differential amplifier (12).
